# EUROPEAN PATENT APPLICATION

(11) **EP 1 752 558 A1**
(43) Date of publication of application: **14.02.2007**
(21) Application number: 05720487.7
(22) Date of filing: 10.03.2005
(51) Int. Cl.: C23C 14/34

(54) **FILM FORMING APPARATUS**

(30) Priority: 12.03.2004 JP 2004070524
(71) Applicant: Shinmaywa Industries, Ltd., Takarazuka-shi, Hyogo 665-8550 (JP); Oshima Electric Works Co., Ltd., Ota-shi, Gunma 373-0847 (JP)
(72) Inventor: YONEYAMA, Nobuo, Hyogo 663-8006 (JP); NAKAYAMA, Takashi, Kanagawa 229-0029 (JP); TAKIGAWA, Shiro, Kyoto 603-8477 (JP); UMEZAWA, Takao, Gunma 371-0216 (JP); ISHIZAWA, Motosuke, Gunma 376-0223 (JP); TAKANO, Hiroshi, Gunma 370-0535 (JP)
(74) Representative: Maxton Langmaack & Partner
(86) International application number: PCT/JP2005/004216
(87) International publication number: WO 2005/087972

(57) **Abstract**

A film forming apparatus which can perform a film forming process to a base material while the base material is being mounted on a die for a molding process. The film forming apparatus is provided with a cylinder-shaped frame body (1h) having one end closed with a bottom part and the other end opened, a target (1a) arranged on an inner plane of the bottom part, and a port (3b) formed to penetrate a wall part of the frame body (1h).

## Description

### Technical Field

The present invention relates to a film forming apparatus, and more particularly, to a film forming apparatus capable of performing film formation on a substrate that is left in a die without being removed therefrom after molding forming.

### Background Art

Conventionally, film formation processing is done with a substrate mounted on a carrier for use in a film forming apparatus or a film forming apparatus itself. Therefore, a substrate for e.g., a lamp reflector for automobiles etc. is removed from the dies after molding forming and then mounted on a film forming apparatus or the like to form a film on it.

### Disclosure of the Invention

### Problem that the Invention is to Solve

As described above, the conventional film forming apparatus require, after molding forming, the preparatory steps of removing the substrate from the dies and mounting it on the film forming apparatus or the like.

A primary object of the invention is to provide a film forming apparatus capable of obviating the need for the preparatory steps, i.e., the removal of a substrate from the dies and mounting of it on the film forming apparatus or the like, by performing film formation on a substrate left in a molding die, thereby reducing the number of steps of processing a product and, in consequence, the processing time and cost of the product.

### Means for Solving the Problem

The above object can be accomplished by a film forming apparatus according to the invention, the apparatus comprising:
a cylindrical frame one end of which is closed by a bottom part while the other end is opened;
a target disposed on an inner surface of the bottom part; and
a port formed so as to penetrate a wall portion of the frame (claim 1). With this arrangement, film formation processing can be performed on a substrate mounted on a die, so that the number of steps of processing a product and, in consequence, the processing time and cost of the product can be reduced.

The target may be disposed so as to be electrically insulated from the wall portion (claim 2).

The bottom part may be electrically conductive (claim 3). This enables potential application to the target through the bottom part, so that the electric system of the film forming apparatus can be simplified.

An electric connection terminal may be disposed at an outer surface of the bottom part (claim 4).

A gate valve may be disposed in the wall portion so as to open and close a communication between the opened end of the frame and the target (claim 5). This enables it to form a preliminary closed space surrounding the main face of the target, so that the time required for vacuuming can be reduced and the target can be protected.

The film forming apparatus may further comprise:
an apparatus section in which the target is placed at its front face and the electric connection terminal is placed at its rear face;
a cylindrical port section in which the port is formed so as to penetrate the wall portion;
an annular electrically insulating spacer;
a gate valve section having a frame in which a through hole provided with an opening/closing gate valve is formed; and
an adaptor section having a frame provided with a through hole and a joint face that is formed on an outer surface of the frame in relation to a joint face of a die, the outer surface surrounding the through hole;
wherein a rear end of the port section is joined through the insulating spacer to a periphery of the target situated at the front face of the apparatus section, and the gate valve section and the adaptor section are joined to a front end of the port section in order,
wherein an inner hole of the insulating spacer, an inner hole of the port section, the through hole of the gate valve section and the through hole of the adaptor section communicate with one another, and the joint face of the adaptor section is located at a front end of the film forming apparatus, the joint face being formed so as to be joinable to the die joint face that surrounds a substrate left in the die (claim 6).

The apparatus section may include a magnet and a cooling system which are located behind the target (claim 7). With this arrangement, magnetron sputtering can be carried out.

A contact-proof portion may be formed on the outer surface of the frame surrounding the through hole of the adaptor section, for covering a specified part of the substrate when the joint face of the adaptor section comes into contact with the die joint face that surrounds the substrate left in the die (claim 8). This makes it possible to exclude the specified part from the area subjected to film formation.

A piping having a valve, a depressurization chamber and a vacuum pump is connected to the port, and this piping is so formed as to selectively change connection between the vacuum pump and the depressurization chamber (claim 9). In this arrangement, the depressurization chamber enables a reduction in the time required for vacuuming.

### Effects of the Invention

As described earlier, the invention has such an effect that since film formation processing can be performed on a substrate that is left on a molding die without being removed therefrom after molding forming, the number of steps of processing a product and, therefore, the processing time and cost for the product can be reduced.

### Brief Description of the Drawings

[Fig. 1] Fig. 1 is views schematically illustrating a film forming apparatus according to a first embodiment of the invention, wherein Figs. 1(a), 1(b), 1(c) are a front view, side view and rear view, respectively.
[Fig. 2] Fig. 2 is an exploded perspective view illustrating a connecting structure of the film forming apparatus shown in Fig. 1.
[Fig. 3] Fig. 3 is a sectional view taken along line III-III of Fig. 1, which illustrates a joining structure of the film forming apparatus, a die and a substrate.
[Fig. 4] Fig. 4 is a flow diagram schematically illustrating a film formation process in which the film forming apparatus shown in Fig. 1 is used.
[Fig. 5] Fig. 5 is a sectional view taken along the same line as in Fig. 3, which illustrates a joining structure of a film forming apparatus according to a second embodiment of the invention, a die and a substrate.
[Fig. 6] Fig. 6 is a piping diagram showing one example of the schematic construction of an exhaust system connected to the film forming apparatus shown in Fig. 5.

### Explanation of Reference Numerals

- 1:: apparatus section
- 1a:: target
- 1b:: magnet
- 1c, 1p:: coolant passage
- 1d:: coolant pipe connection portion
- 1e:: joint face
- 1f:: electric connection terminal
- 1g:: bolt insertion hole
- 1h:: frame
- 2:: insulating spacer
- 2c:: inner hole
- 2g:: bolt insertion hole
- 3:: port section
- 3a:: port
- 3b:: pipe connection portion
- 3c;: inner hole
- 3e:: first end face
- 3f:: second end face
- 3g:: threaded hole
- 3j:: bolt insertion hole
- 4;: gate valve section
- 4a:: valve body
- 4b:: valve body movement space
- 4c:: through hole
- 4e; 4f:: joint face
- 4j:: threaded hole
- 4k:: threaded hole
- 4n, 4m:: boss portion
- 5:: adaptor section
- 5a:: contact-proof portion
- 5b:: 0-ring
- 5c:: through hole
- 5e:: first face
- 5f:: end face on the opened side (second face)
- 5k:: bolt insertion hole
- 7, 8, 9:: bolt
- 11:: insulating guide
- 13:: port section
- 13a:: port
- 13b:: pipe connection portion
- 13c:: inner hole
- 13e:: first end face
- 13f:: second end face
- 13k:: threaded hole
- 15:: recess portion
- 15a:: stepped portion
- 21, 22, 23:: pipe
- 24:: depressurization chamber
- 50:: central axis
- 61:: molding cavity
- 100, 110:: film forming apparatus
- 200:: exhaust system
- A:: preliminary closed space
- B:: closed space
- C:: closed space
- V1, V2, V3:: valve
- P1:: first vacuum pump
- P2:: second vacuum pump
- W:: substrate
- Wa:: film forming face
- P:: die
- Pa:: die joint face
- P':: die

### Best Mode for Carrying out the Invention

Referring now to the accompanying drawings, the best mode for carrying out the invention will be described.

### (First Embodiment)

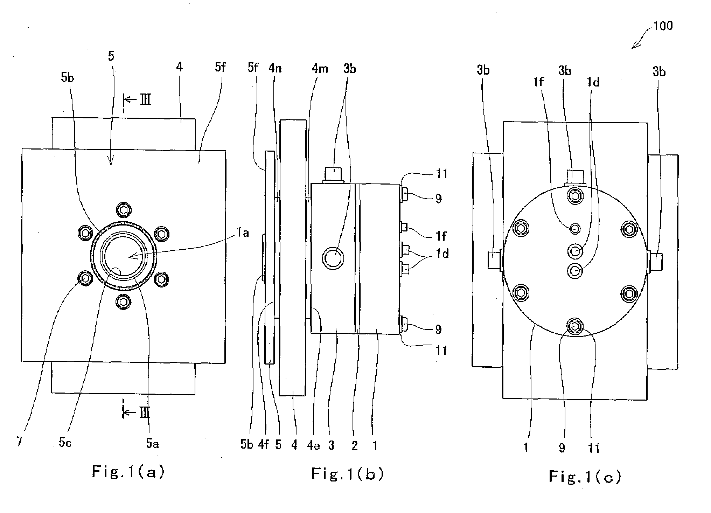

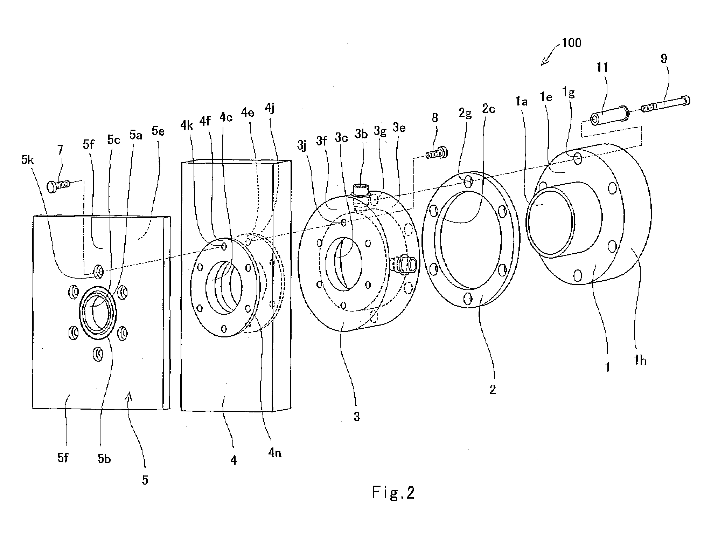

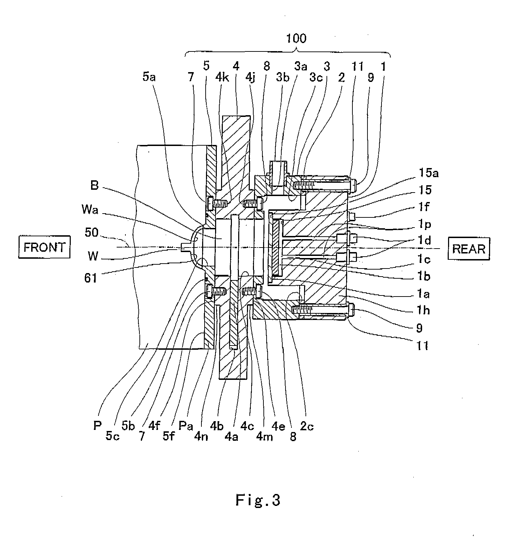

Fig. 1 is views schematically illustrating a film forming apparatus 100 according to a first embodiment of the invention, wherein Figs. 1(a), 1(b), 1(c) are a front view, side view and rear view, respectively. Fig. 2 is an exploded perspective view illustrating a connecting structure of the film forming apparatus 100 shown in Fig. 1. Fig. 3 is a sectional view taken along line III-III of Fig. 1, which illustrates a joining structure of the film forming apparatus 100, a die P and a substrate W. It should be noted that Fig. 3 shows only some screws 7, 8, 9 and insulating guide 11 and omits their identical screws etc.

First of all, the whole structure will be described. As shown in Figs. 1 to 3, the film forming apparatus 100 is formed in the shape of a cylinder, on the whole, that is closed by a bottom part (i.e., apparatus section 1) at an end thereof and opened at the other end thereof. A target 1a is disposed at the inner surface of the bottom part and an annular joint face is formed at an end face 5f on the opened side. As described later, in the cylindrical film forming apparatus 100, the target 1a is formed so as to be electrically insulated from a wall face defining an inner hole 2c, a wall face defining an inner hole 3c, a wall face defining a through hole 4c, a wall face defining a through hole 5c and the end face 5f on the opened side. The film forming apparatus 100 has one or a plurality of ports 3a that make a closed space B communicate with the outside of the film forming apparatus 100.

The film forming apparatus 100 is made up of separated parts, i.e., the apparatus section 1, an insulating spacer 2, a port section 3, a gate valve section 4, and an adaptor section 5. These parts are integrated, being fastened to one another by means of bolts 7, 8, 9, such that the main face of the target 1a of the apparatus section 1, the inner hole 2c of the spacer 2, the inner hole 3c of the port section 3, the through hole 4c of the gate valve section 4 and the through hole 5c of the adaptor section 5 have a common central axis 50. Thereby, the closed space B is formed in the shape of a column which bottom face is defined by the target 1a. Further, these members are integrated with seal members (not shown) such as O-rings interposed between their joint faces, so that the closed space B has an air tight structure.

The structure of each member will be hereinafter described in detail. In the following description, the direction from the apparatus section 1 toward the adaptor section 5 is defined as "forward direction".

The apparatus section 1 has a frame 1h made of a rigid material. As illustrated in Fig. 3, the frame 1h takes the form of a stepped cylinder in which a small diameter portion projects from the front end face of a large diameter portion and the small and large diameter portions have the central axis 50 as their common axis. The target 1a is disposed at the front end face of the small diameter portion. Specifically, a recess portion 15 having a stepped portion 15a is formed at the front end face of the small diameter portion and the target 1a is liquid-tightly disposed in the stepped portion 15a. At the rear face of the target 1a, a magnet 1b is placed, with a gap (coolant passage 1c) between the magnet 1b and the inner surface of the recess portion 15. A pair of coolant passages 1p extend from the bottom face of the recess portion 15 to the rear end face of the large diameter portion. A pair of coolant pipe connection portions 1d are provided in the openings of the pair of coolant passages 1p respectively so as to project from the rear end face of the large diameter portion, that is, the rear face of the apparatus section 1. One of the coolant pipe connection portions 1d is an inlet for the coolant whereas the other is an outlet for the coolant. Thereby, a path for a coolant is so established that the coolant enters from one of the coolant pipe connection portions 1d and flows out from the other coolant pipe connection portion 1d after flowing in one of the coolant passages 1p, the coolant passage 1c and the other coolant pipe passage 1p in order. As a result, the target 1a and the magnet 1b can be cooled.

The stepped portion of the apparatus section 1 constitutes a joint face 1e. Formed at the joint face 1e are a plurality of bolt insertion holes 1g that pass through the large diameter portion.

Projectingly formed at the rear face of the frame 1h is an electric connection terminal 1f that is electrically connected to the target 1a. Herein, the frame 1h is made of a metal having high electric conductivity, so that the electric connection terminal 1f and the target 1a are electrically connected to each other.

The port section 3 is cylindrical in shape. A first end face 3e, which is the rear end face of the port section 3, has an annular shape joinable to the joint face 1e of the apparatus section 1. More specifically, the first end face 3e has substantially the same outer diameter as of the large diameter portion of the apparatus section 1 and larger inner diameter (the diameter of the inner hole 3c) than the small diameter portion of the apparatus section 1. In the first end face 3e, threaded holes 3g are so formed as to correspond to the bolt insertion holes 1g of the apparatus section 1. The ports 3a are so formed as to pierce the wall portion of the port section 3. While three ports 3a are formed herein, being aligned in a circumferential direction, one or a plurality of ports 3a may be used. Pipe connection portions 3b are provided in the openings of the ports 3a that pass through the outer circumferential face of the port section 3. The wall portion of the port section 3 includes an extending portion that inwardly extends from the front end of the port section 3, and a plurality of bolt insertion holes 3j are so formed as to penetrate this extending portion.

The insulating spacer 2 is in the form of a hollow disk having substantially the same outer diameter and inner diameter (the diameter of the inner hole 2c) as of the first end face 3e of the port section 3. Formed in the insulating spacer 2 are bolt insertion holes 2g that correspond to the bolt insertion holes 1g of the apparatus section 1. The insulating spacer 2 is made of an electrically insulating elastic material such as a rubber packing, in order to electrically insulate and seal between the joint face 1e of the apparatus section 1 and the first end face 3e of the port section 3.

Now, the connecting structure of the apparatus section 1, the insulating spacer 2 and the port section 3 will be explained. The apparatus section 1 and the port section 3 are integrally fastened to each other by bolts 9 with the insulating spacer 2 being interposed between the joint face 1e and the first end face 3e. Thereby, the apparatus section 1 and the port section 3 are not in direct contact with each other but arranged such that the insulating spacer 2 is present in all the spaces between the joint face 1e and the first end face 3e which are opposed to each other. For fastening these sections 1, 3 with the bolts 9, electrically insulating guides 11 in the form of a cylinder having a collar are used. Specifically, each insulating guide 11 is inserted into the bolt insertion holes 1g, 2g and each bolt 9 is screwed into and stopped at a threaded hole 3g of the port section 3, after passing through the insulating guide 11. This prevents electrical continuity between the apparatus section 1 and the port section 3 through the bolts 9.

The entire gate valve section 4 is the form of a rectangular plate having a through hole 4c at the center thereof. Formed in the gate valve section 4 is a plate-shaped valve body movement space 4b that traverses the through hole 4c. In the valve body movement space 4b, a plate-shaped valve body 4a is accommodated so as to be slidable in the valve body movement space 4b, thereby opening and closing the through hole 4c. The valve body 4a is connected to an actuator (not shown) such as a piston rod for air cylinders and is slidingly actuated by this actuator, thereby opening and closing the through hole 4c. The sliding part between the actuator and the gate valve section is properly sealed so that the valve body movement space 4b is kept hermetic relative to the outside and therefore outside air does not penetrate when the valve body 4a is in sliding movement. The through hole 4c is formed so as to have a larger cross-sectional area than a film forming face Wa of a substrate W. Boss portions 4n, 4m are arranged so as to surround both openings of the through hole 4c, respectively. The end faces of the boss portions 4n, 4m constitute joint faces 4e, 4f, respectively. In the joint face 4e, threaded holes 4j are formed so as to correspond to the bolt insertion holes 3j of the port section 3. In the joint face 4f, threaded holes 4k are formed. Concretely, the gate valve section 4 of the first embodiment is constituted by the known gate valve (high-vacuum gate valve (with a protect ring) produced by VAT SKK VACUUM Ltd.) for use in vacuum equipment.

The gate valve section 4 is integrally fastened to the port section 3 by bolts 8 such that the through hole 4c and the inner hole 3c have the central axis 50 as their common axis and the joint face 4e is joined to a second joint face 3f of the port section 3. Each bolt 8 is screwed into and stopped at a threaded hole 4j of the gate valve section 4, after passing through the bolt insertion hole 3j of the port section 3. The joint part where the second end face 3f of the port section 3 and the joint face 4e of the gate valve section 4 are joined is sealed by a sealing member (not shown).

Herein, the adaptor section 5 is formed in the shape of a square plate and has the through hole 5c formed at the center thereof. A first face 5e, which is the rear face of the adaptor section 5, constitutes a joint face joined to a joint face 4f of the gate valve section 4. In addition, the second face 5f, which is the front face of the adaptor section 5, constitutes a joint face to be joined to a joint face Pa of a die P. The second face 5f has an annular contact-proof portion 5a that surrounds the opening of the through hole 5c.

The joint face Pa of the die P is provided with a molding cavity 61 in which the substrate W is molded. The opening of the through hole 5c of the adaptor section 5 is formed such that when the adaptor section 5 is joined to the die P, the surface Wa (hereinafter referred to as "film forming face") of the substrate W on which a film is to be formed is exposed to the through hole 5c (i.e., the closed space B of the film forming apparatus 100). Specifically, the wall face defining the through hole 5c is formed so as to coincide with the outer periphery of the film forming face Wa such that film formation does not take place in the die joint face Pa. Since the outer periphery of the film forming face Wa includes a face which should not be filmed (hereinafter referred to as "non-filmed face") in some cases depending on the substrate W required, the annular contact-proof portion 5a is provided on the rim of the through hole 5c of the adaptor section 5 so as to come into contact with the non-filmed face of the substrate W to cover it when the adaptor section 5 is joined to the die P. One example of the non-filmed face of the substrate W is the joint faces of a substrate that is joined to other parts. In molding the substrate W, the outer periphery of the substrate W is sometimes formed in a position anterior to the die joint face Pa (based on the drawings), that is, a position set back from the die joint face Pa. Therefore, the contact-proof portion 5a is convex in shape.

The second face 5f of the adaptor section 5 is provided with spot facings (concave portions) that are located at positions corresponding to the threaded holes 4k of the gate valve section 4, for accommodating the heads of bolts 7. Each of these spot facings is formed a bolt insertion hole 5k. In addition, the second face 5f is provided with an O-ring 5b that is formed so as to surround the contact-proof portion 5a.

The adaptor section 5 is integrally fastened to the gate valve section 4 by the bolts 7 such that the through hole 5c and the through hole 4c of the gate valve section 4 have the central axis 50 as their common axis and the joint face 5e is joined to the joint face 4f of the gate valve section 4. The bolts 7 are screwed into and stopped at their associated threaded holes 4k of the gate valve section 4, after passing through their associated bolt insertion holes 5k of the adaptor section 5. The heads of the bolts 7 are housed in the spot facings of the bolt insertion holes 5k, and therefore, the heads of the bolts 7 are prevented from coming into contact with the die P when the die P is joined to the adaptor section 5. Additionally, the joint part where the first face 5e of the adaptor section 5 and the joint face 4f of the gate valve section 4 are joined is sealed by a sealing member (not shown).

Thus, the film forming apparatus 100 is constructed by joining the apparatus section 1, the insulating spacer 2. the port section 3, the gate valve section 4 and the adaptor section 5 in order.

Next, the operation of the film forming apparatus 100 having the above structure will be described.

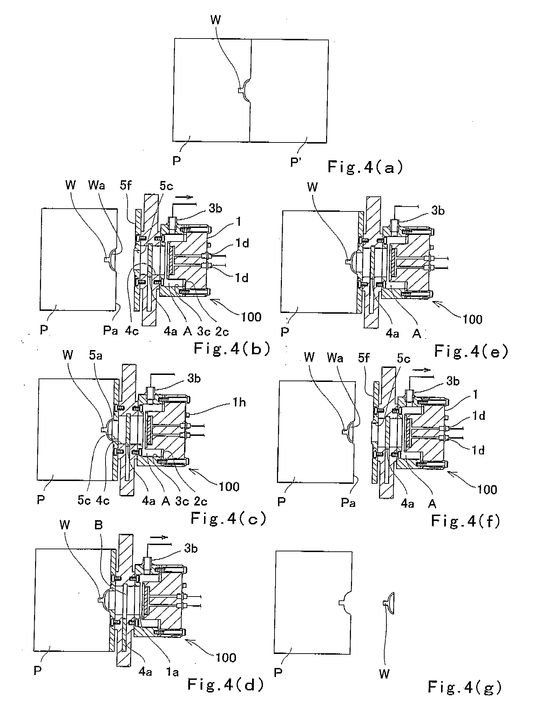

Fig. 4 is a flow diagram schematically illustrating a film formation process in which the film forming apparatus shown in Fig. 1 is used. The film forming apparatus 100 in Fig. 4 is illustrated by simplifying the sectional view of Fig. 3.

As illustrated in Fig. 4(a), the substrate W is molded by the dies P, P'.

After the molding, the die joint faces of the dies P, P' are separated from each other as illustrated in Fig. 4(b). The substrate W is left in the die P with its film forming face W exposed.

In the film forming apparatus 100, the valve body 4a is actuated by the actuator (not shown) through a specified operation to close the through hole 4c, so that the preliminary closed space A is formed by the valve body 4a, the inner holes 2c, 3c, the through hole 4c and the apparatus section 1. In the pipe connection portion 3b, a pipe (not shown) is connected to a known vacuum pump (not shown). The preliminary closed space A is brought into a vacuum condition under a specified pressure by this vacuum pump. By making the space A vacuum beforehand, the time required for vacuuming after joining the film forming apparatus 100 to the substrate W can be reduced. In addition, damage to the target 1a and, particularly, oxidation can be prevented by bringing the gate valve section 4 into a closed state and placing the target 1 in vacuum atmosphere.

Pipes are connected to the coolant pipe connection portions 1d respectively from outside and a coolant flows in the coolant passages 1p, 1c.

All the pipe connection portions 3b are not necessarily connected to a vacuum pump and some of them may be connected to a known gas feeder through a shut-off valve, for the purpose of feeding discharge gas such as argon gas and reactive gas such as methane gas.

As illustrated in Fig. 4(c), either the die P or the film forming apparatus 100 or both of them are moved, thereby joining the second face 5f of the adaptor section 5 of the film forming apparatus 100 to the die joint face Pa of the die P. Joining of the die joint face Pa to the film forming apparatus 100 is done such that the film forming face Wa of the substrate W is opposed to the through hole 5c; the whole circumference of the O-ring 5b is joined to the mold joint face Pa; and the contact-proof portion 5a is brought into contact with a specified position of the substrate W (so as to cover the specified position). Herein, the film forming apparatus 100 is supported by a supporting structural member (not shown) such as a machine casing and a joining force is applied to the film forming apparatus 100 from its rear side. In this supporting mechanism, since voltage for sputtering is applied to the apparatus section 1, the film forming apparatus 100 needs to be supported at other parts than the apparatus section 1. For example, the film forming apparatus 100 may be supported at the adaptor section 5.

As illustrated in Fig. 4(d), the valve body 4a is retracted from the through hole 4c, being actuated by the actuator (not shown) through a specified operation, so that the closed space B is formed by the film forming face Wa, the contact-proof portion 5a, the through holes 5c, 4c, the inner holes 3c, 2c and the apparatus section 1. Then, air is evacuated by the vacuum pumps through the ports 3a and the pipe connection portions 3b, so that the closed space B is brought into a highly vacuum condition. Since the preliminary closed space A is brought into the vacuum condition beforehand, vacuuming after releasing the valve body 4a can be performed in a short time. The 0-ring 5b is inserted between the die joint face Pa and the adaptor section 5 thereby to prevent an inflow of outside air.

A specified voltage is applied to the target 1a (more particularly, between the electric connection terminal 1f and the port section 3) and the film forming material which has been sputtered from the target 1a and moved to the closed space B. Then, the forming material is deposited on the film forming face Wa of the substrate W, thus forming a film over the film forming face Wa. In short, the closed space B functions as a vacuum chamber. Since the substrate W and other elements than the apparatus section 1 are electrically insulated from the apparatus section 1 by the insulating spacer 2 and the insulating guide 11, a potential difference can be caused between the target 1a and the other elements than the apparatus section 1/the substrate W by applying voltage to the electric connection terminal 1f of the apparatus section 1. Herein, the magnet 1b is disposed behind the target 1a and therefore magnetron sputtering is carried out.

This film formation process is similar to the process performed by the known film forming apparatus. It should be noted that discharge gas and/or reactive gas may be introduced through some of the ports 3a.

As illustrated in Fig. 4(e), after completion of the film formation, the valve body 4a is actuated by the actuator through a specified operation to close the through hole 4c. Thereby, the vacuum condition of the preliminary closed space A can be maintained.

Then, the die P and the film forming apparatus 100 are separated from each other as illustrated in Fig. 4(f).

Subsequently, the substrate W having a film formed thercon is removed from the die P as illustrated in Fig. 4(g).

While the above description is associated with a case where magnetron sputtering is used, various vacuum film formation techniques may be applied to the invention. Since the invention can utilize the closed space B as a vacuum chamber, use of various vacuum film formation techniques may be applied by changing the arrangement of the devices disposed in the wall face of the closed space B opposed to the film forming face Wa of the substrate W, such as the mounting position of the target 1a.

### (Second Embodiment)

A second embodiment of the invention is associated with a film forming apparatus 110 that exemplifies apparatus which do not use the gate valve section 4 of the first embodiment.

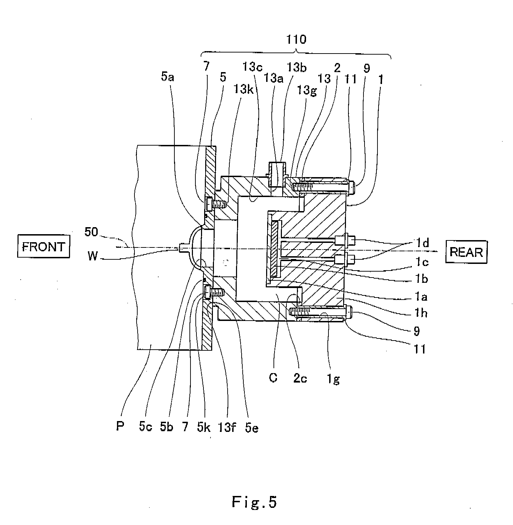

Fig. 5 is a sectional view taken along the same line as in Fig. 3, which illustrates a joining structure of the film forming apparatus 110, the die P and the substrate W.

The film forming apparatus 110 is composed of the apparatus section 1, the insulating spacer 2, a port section 13 and the adaptor section 5 which are integrally joined in order by means of the bolts 7, 9. The film forming apparatus 110 does not differ from the film forming apparatus 100 of the first embodiment except that the apparatus 110 is not provided with the gate valve section 4, and that the apparatus 110 is not provided with the port section 13 which differs in shape from the port section 3.

Herein, the port section 13 is formed such that a second end face 13f is joined to the first face 5e of the adaptor section 5. Threaded holes 13k are so formed in the second end face 13f as to correspond to the bolt insertion holes 5k. The extending portion that inwardly extends from the second end face 13f is thicker than the extending portion that inwardly extends from the second end face 3f of the first embodiment.

Other elements are the same as those of the film forming apparatus 100 and therefore an explanation of them will be skipped.

The adaptor section 5 is integrally fastened to the port section 13 by the bolts 7 such that the through hole 5c and the inner hole 13c of the port section 13 have the central axis 50 as their common axis and such that the first face 5e is joined to the second end face 13f of the port section 13. The bolts 7 are screwed into and stopped at their associated threaded holes 13k, after passing through their associated bolt insertion holes 5k.

The joint part where the first face 5e and the second end face 13f are joined is properly sealed.

The operation of the film forming apparatus 110 of the second embodiment having the above structure does not differ from that of the film forming apparatus 100 of the first embodiment except that the former does not involve the operation of the gate valve section 4.

In the film forming apparatus 110, after joining the film forming apparatus 110 to the die P, a closed space C formed by the film forming face Wa, the contact-proof portion 5a, the through hole 5c, the inner hole 13c, the inner hole 2c and the apparatus section 1 is vacuumed through ports 13a and pipe connection portions 13b.

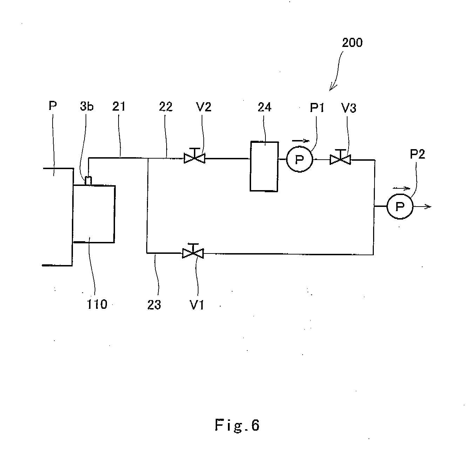

Fig. 6 is a piping diagram showing one example of the schematic construction of an exhaust system 200 connected to the film forming apparatus 110 shown in Fig. 5.

The exhaust system 200 is composed of pipes 27, 22, 23, vacuum pumps P1, P2, a depressurization chamber 24 and valves V1, V2, V3.

The pipe 21 is connected to the pipe connection portion 13b at one end and to first ends of the pipes 22, 23 at the other end.

A second end of the pipe 22 is connected to a suction port of the second vacuum pump P2. The pipe 22 is provided with a valve V2, a depressurization chamber 24, a first vacuum pump P1 and a valve V3 which are aligned in this order when viewed from the first end. The suction port of the first vacuum pump P1 is connected to the depressurization chamber 24.

The pipe 23 has a valve V1 disposed in the middle thereof and is connected, at the second end, to the suction port of the second vacuum pump P2.

The operation of the exhaust system 200 having the above structure will be explained.

In Fig. 6, the valves V1, V2 are first closed and then, the valve V3 is opened. Subsequently, the first vacuum pump P1 and the second vacuum pump P2 are operated. A part of the pipe 22 situated between the valve V2 and the vacuum pump P1. as well as the depressurization chamber 24 is brought into a highly vacuum condition. A part of the pipe 22 situated between the vacuum pump P1 and the vacuum pump P2 and a part of the pipe 23 situated between the valve V1 and the vacuum pump P2 are brought into a vacuum condition.

Thereafter, the valve V3 is closed and the valve V1 is opened. After the degree of vacuum of the closed space C has reached a certain value, the valve V1 is closed whereas the valve V2 is opened so that the closed space C is allowed to communicate with the depressurization chamber 24. Thereby, the time required for vacuuming the closed space C can be reduced.

### Industrial Applicability

Since the invention enables it to apply film formation to a substrate which is left in a molding die without being removed therefrom after molding forming, the invention is useful as a film forming apparatus capable of reducing the number of steps of processing a product and, in consequence, the time required for processing the product.

## Claims

1. A film forming apparatus comprising:
a cylindrical frame one end of which is closed by a bottom part while the other end is opened;
a target disposed on an inner surface of the bottom part; and
a port formed so as to penetrate a wall portion of the frame.

2. The film forming apparatus according to claim 1,
wherein said target is disposed so as to be electrically insulated from the wall portion.

3. The film forming apparatus according to claim 2,
wherein said bottom part is electrically conductive.

4. The film forming apparatus according to claim 3, further comprising:
an electric connection terminal disposed at an outer surface of the bottom part.

5. The film forming apparatus according to claim 1,
wherein a gate valve is disposed in the wall portion so as to open and close a communication between the opened end of said frame and said target.

6. The film forming apparatus according to claim 5, further comprising:
an apparatus section in which said target is placed at its front face and said electric connection terminal is placed at its rear face;
a cylindrical port section in which said port is formed so as to penetrate the wall portion;
an annular electrically insulating spacer;
a gate valve section having a frame in which a through hole provided with an opening/closing gate valve is formed; and
an adaptor section having a frame provided with a through hole and a joint face that is formed on an outer surface of the frame in relation to a joint face of a die, the outer surface surrounding the through hole;
wherein a rear end of said port section is joined through said insulating spacer to a periphery of said target situated at the front face of the apparatus section, and said gate valve section and said adaptor section are joined to a front end of said port section in order,
wherein an inner hole of said insulating spacer, an inner hole of said port section, the through hole of said gate valve section and the through hole of said adaptor section communicate with one another, and the joint face of said adaptor section is located at a front end of the film forming apparatus, the joint face being formed so as to be joinable to the die joint face that surrounds a substrate left in the die.

7. The film forming apparatus according to claim 6,
wherein said apparatus section includes a magnet and a cooling system which are located behind said target.

8. The film forming apparatus according to claim 6,
wherein a contact-proof portion is formed on the outer face of the frame surrounding the through hole of said adaptor section, for covering a specified part of the substrate when the joint face of said adaptor section comes into contact with the die joint face that surrounds the substrate left in the die.

9. The film forming apparatus according to claim 1,
wherein a piping having a valve, a depressurization chamber and a vacuum pump is connected to said port, and
wherein said piping is so formed as to selectively change connection between the vacuum pump and the depressurization chamber.
